# EUROPEAN PATENT APPLICATION

(11) **EP 4 600 960 A1**
(43) Date of publication of application: **13.08.2025**
(21) Application number: 24861352.3
(22) Date of filing: 28.10.2024
(51) Int. Cl.: G11C 11/4097

(54) **MEMORY, BIT LINE CONTROL METHOD, AND ELECTRONIC DEVICE**

(30) Priority: 26.12.2023 CN 202311829091
(71) Applicant: CXMT Corporation, Hefei, Anhui 230601 (CN)
(72) Inventor: SI, Shufang, Hefei Anhui 230601 (CN)
(74) Representative: Gulde & Partner
(86) International application number: PCT/CN2024/127588
(87) International publication number: WO 2025/139308

(57) **Abstract**

The present disclosure provides a memory, a bit line control method, and an electronic device. In a first chip of the memory, each memory array tile includes multiple storage layer groups sequentially stacked in a third direction. In an odd-numbered storage layer group, each local bit line is coupled to a respective first common bit line through a respective bit line selector, and each local bit line is coupled to a respective second common bit line through a respective precharge switch. **In** an even-numbered storage layer group, each local bit line is coupled to a respective first common bit line through a respective precharge switch, and each local bit line is coupled to a respective second common bit line through a respective bit line selector.

## Description

This application claims priority to Chinese Patent Application No. 202311829091.5, filed with the China National Intellectual Property Administration on December 26, 2023 and entitled "MEMORY, BIT LINE CONTROL METHOD, AND ELECTRONIC DEVICE", which is incorporated herein by reference in its entirety.

### TECHNICAL FIELD

The present disclosure relates to the semiconductor field, and in particular, to a memory, a bit line control method, and an electronic device.

### BACKGROUND

With development of semiconductor technologies, semiconductor memories are widely applied to electronic apparatuses. A dynamic random access memory (DRAM) belongs to a volatile memory, and the dynamic random access memory is usually utilized as a cache due to a fast access speed.

Two parts, that is, a peripheral circuit (Periphery) and a memory array (core) are mainly included in the dynamic random access memory. To further increase the storage density, in a three-dimensional DRAM (3D DRAM), the peripheral circuit (Periphery) and the memory array (core) are respectively disposed in two independent chips, and then the two chips are connected to each other in a bonding manner. However, for an existing 3D DRAM, there is a serious local bit line-to-bit line coupling problem (BL-to-BL Coupling), resulting in a loss of sensing margin.

### SUMMARY

Embodiments of the present disclosure provide a memory, a bit line control method, and an electronic device.

The technical solutions of the present disclosure are implemented as follows.

According to a first aspect, the present disclosure provides a memory, where the memory includes a first chip, the first chip includes multiple memory array tiles, and each of the memory array tiles includes multiple storage layer groups stacked sequentially in a third direction; each of the storage layer groups has multiple local bit lines extending in a first direction, and the multiple local bit lines are sequentially arranged in a second direction; and a first side of each of the storage layer groups has a first common bit line, a second side of each of the storage layer groups has a second common bit line, the first side and the second side are opposite to each other in the first direction, the first direction intersects the second direction, and the third direction is perpendicular to the first direction and perpendicular to the second direction; and each of the storage layer groups further includes multiple bit line selectors and multiple precharge switches; and the multiple storage layer groups are numbered in the third direction: in an odd-numbered one of the storage layer groups, each of the local bit lines is coupled to a respective first common bit line through a respective bit line selector, and each of the local bit lines is coupled to a respective second common bit line through a respective precharge switch; and in an even-numbered one of the storage layer groups, each of the local bit lines is coupled to a respective first common bit line through a respective precharge switch, and each of the local bit lines is coupled to a respective second common bit line through a respective bit line selector.

In some embodiments, a first stair contact structure is further disposed on a first side of the first common bit line, a second stair contact structure is further disposed on a second side of the second common bit line, and both the first stair contact structure and the second stair contact structure are connected to a sense amplification region; and a first common bit line of the odd-numbered storage layer group is connected to the first stair contact structure, and a second common bit line of the even-numbered storage layer group is connected to the second stair contact structure.

In some embodiments, both the first stair contact structure and the second stair contact structure include multiple stairs; each first common bit line of the odd-numbered storage layer group is coupled to one sense amplifier in the sense amplification region through one stair of the first stair contact structure; and each second common bit line of the even-numbered storage layer group is coupled to one sense amplifier in the sense amplification region through one stair of the second stair contact structure.

In some embodiments, for the first stair contact structure, several successive stairs form one stair group, and multiple stair groups are arranged at an interval in the second direction; and for the second stair contact structure, several successive stairs form one stair group, and multiple stair groups are arranged at an interval in the second direction.

In some embodiments, the memory further includes a second chip, the first chip and the second chip are stacked in the third direction, and the first chip is bonded to the second chip; and the sense amplification region is located in the second chip.

In some embodiments, each of the memory array tiles further includes multiple local word lines, and each of the local word lines runs through multiple storage layer groups in the third direction.

In some embodiments, the memory further includes multiple common word lines extending in the second direction, and multiple ones of the local word lines aligned in the second direction are coupled to a same common word line.

In some embodiments, the storage layer group further includes multiple memory cells, and each of the memory cells is separately connected to one of the local bit lines and one of the local word lines; and
the memory is configured to: in a process of a read operation or a write operation, for a selected memory cell, control the bit line selector of the local bit line connected to the selected memory cell to be in an on state, and control the precharge switch of the local bit line connected to the selected memory cell to be in an off state; and for an unselected memory cell, control the bit line selector of the local bit line connected to the unselected memory cell to be in an off state, and control the precharge switch of the local bit line connected to the unselected memory cell to be in an on state.

In some embodiments, in the odd-numbered storage layer group, each precharge switch is located on a third side of the corresponding local bit line, and each bit line selector is located on a fourth side of the corresponding local bit line; and the third side and the fourth side are opposite to each other in the second direction; and
in the even-numbered storage layer group, each precharge switch is located on a fourth side of the corresponding local bit line, and each bit line selector is located on a third side of the corresponding local bit line.

In some embodiments, both the bit line selector and the precharge switch are CMOS switches.

According to a second aspect, an embodiment of the present disclosure provides a bit line control method, applied to the memory of the first aspect, where the method includes the steps as follows:

Based on an address signal, multiple local bit lines aligned in a third direction are selected from a target memory array tile; and
in an odd-numbered storage layer group, a selected local bit line is controlled to be electrically connected to a first common bit line of a storage layer group to which the local bit line belongs, and an unselected local bit line is controlled to be electrically connected to a second common bit line of a storage layer group to which the local bit line belongs; and in an even-numbered storage layer group, a selected local bit line is controlled to be electrically connected to a second common bit line of a storage layer group to which the local bit line belongs, and an unselected local bit line is controlled to be electrically connected to a first common bit line of a storage layer group to which the local bit line belongs.

In some embodiments, the method further includes the steps as follows.

A bit line selector of the selected local bit line is controlled to be in an on state, and a precharge switch of the selected local bit line is controlled to be in an off state, so that the selected local bit line in the odd-numbered storage layer group is electrically connected to the first common bit line, and the selected local bit line in the even-numbered storage layer group is electrically connected to the second common bit line; and
a bit line selector of the unselected local bit line is controlled to be in an off state, and a precharge switch of the unselected local bit line is controlled to be in an on state, so that the unselected local bit line in the odd-numbered storage layer group is electrically connected to the second common bit line, and the unselected local bit line in the even-numbered storage layer group is electrically connected to the first common bit line.

In some embodiments, the method further includes the steps as follows: A potential of the second common bit line is controlled to be a precharge potential for the odd-numbered storage layer group; and a potential of the first common bit line is enabled to be a low potential or a high potential through charge sharing and sense amplification processing; and a potential of the first common bit line is controlled to be a precharge potential for the even-numbered storage layer group; and a potential of the second common bit line is enabled to be a low potential or a high potential through charge sharing and sense amplification processing; where the low potential < the precharge potential < the high potential.

According to a third aspect, an embodiment of the present disclosure provides an electronic device, and the memory according to the first aspect is included in the electronic device.

Embodiments of the present disclosure provide a memory, a bit line control method, and an electronic device. For an odd-numbered storage layer group, a local bit line is connected to a first common bit line through a bit line selector, and is connected to a second common bit line through a precharge switch. For an even-numbered storage layer group, a local bit line is connected to a second common bit line through a bit line selector, and is connected to a first common bit line through a precharge switch. In addition, all first common bit lines are sequentially arranged in a direction perpendicular to the storage layer group, and all second common bit lines are arranged in the direction perpendicular to the storage layer group. In this way, in a process of sense amplification processing, for two first common bit lines adjacent in a third direction, it is inevitable that one first common bit line is in a sense amplification state (a high potential or a low potential), and the other first common bit line is at a precharge potential. For two second common bit lines adjacent in the third direction, it is inevitable that one second common bit line is in a sense amplification state (a high potential or a low potential), and the other second common bit line is at a precharge potential. Therefore, coupling of adjacent common bit lines obviously weakens, thereby increasing a sensing margin.

### BRIEF DESCRIPTION OF DRAWINGS

FIG. 1A is a schematic structural diagram of a memory array tile in a first chip;
FIG. 1B is a schematic diagram of a partial structure of a memory array tile;
FIG. 2 is a specific schematic structural diagram of a memory array tile;
FIG. 3 is a schematic diagram of a bit line-to-bit line coupling effect in a memory array tile;
FIG. 4 is a schematic structural diagram of a memory array tile in a first chip according to an embodiment of the present disclosure;
FIG. 5A is a schematic top view of a storage layer group;
FIG. 5B is a schematic top view of a storage layer group according to an embodiment of the present disclosure;
FIG. 6 is a schematic structural diagram of a memory array tile in another first chip according to an embodiment of the present disclosure;
FIG. 7 is a schematic diagram of a partial structure of a memory according to an embodiment of the present disclosure;
FIG. 8 is a schematic structural diagram of a memory array tile in another first chip according to an embodiment of the present disclosure;
FIG. 9 is a schematic stacked structural diagram of a memory according to an embodiment of the present disclosure;
FIG. 10 is a schematic structural diagram of a memory array tile in a first chip according to an embodiment of the present disclosure;
FIG. 11 is a schematic diagram of a working state of a memory array tile according to an embodiment of the present disclosure;
FIG. 12 is a schematic diagram of a bit line-to-bit line coupling effect in a memory array tile according to an embodiment of the present disclosure; and
FIG. 13 is a schematic flowchart of a bit line control method according to an embodiment of the present disclosure.

### DESCRIPTION OF EMBODIMENTS

To make the objectives, technical solutions, and advantages of the present disclosure clearer, the technical solutions of the present disclosure are further described in detail below with reference to the accompanying drawings and the embodiments. The described embodiments should not be considered as limitations to the present disclosure. All other embodiments obtained by a person of ordinary skill in the art without creative efforts fall within the scope of the present disclosure.

The following descriptions relate to "some embodiments" describing a subset of all possible embodiments. However, it may be understood that "some embodiments" may be the same subset or different subsets of all the possible embodiments, and may be combined with each other when there is no conflict.

The following descriptions are added if descriptions such as "first/second" appear in the application document. In the following descriptions, involved terms "first/second/third" are merely for distinguishing between similar objects and do not represent specific rankings of the objects. It may be understood that "first/second/third" may be interchanged for a specific sequence or order if allowed, so that the embodiments of the present disclosure described herein can be implemented in a sequence other than those shown or described herein.

Unless otherwise defined, all technical and scientific terms employed in this specification have meanings the same as those commonly understood by a person skilled in the technical field of the present disclosure. The terms employed in this specification are merely intended to describe the embodiments of the present disclosure, but are not intended to limit the present disclosure.

Explanations of nouns:
word line (WL);
bit line (BL);
complementary metal oxide semiconductor (CMOS);
through silicon via (TSV); and
memory array tile (MAT).

Before the embodiments of the present disclosure are described, three directions that may be employed to describe three-dimensional structures in planes in the following embodiments are first defined. For example, in a Cartesian coordinate system, the three directions may include a first direction, a second direction, and a third direction.

A semiconductor chip may include a top surface located on the front and a bottom surface located on the back opposite to the front. When flatness of the top surface and the bottom surface is ignored, a direction intersecting with (e.g., perpendicular to) the top surface and the bottom surface of the semiconductor chip is defined as a third direction. In addition, an extension direction of a local bit line in the semiconductor chip is defined as a first direction, an extension direction of a local word line in the semiconductor chip is defined as a second direction, and the first direction intersects the second direction.

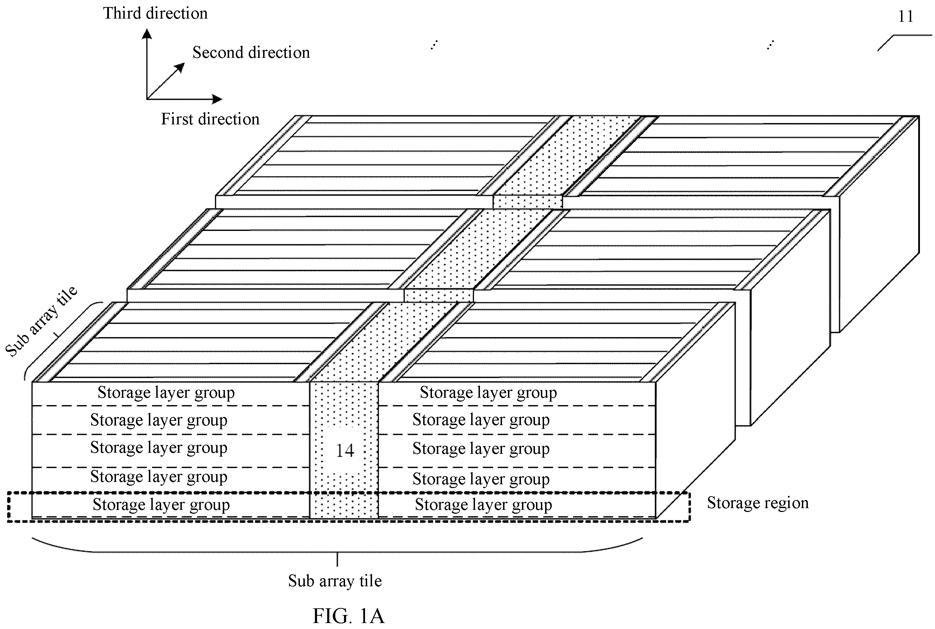

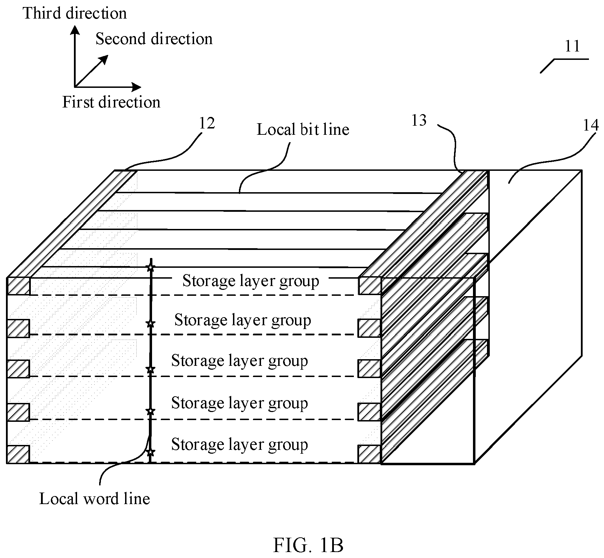

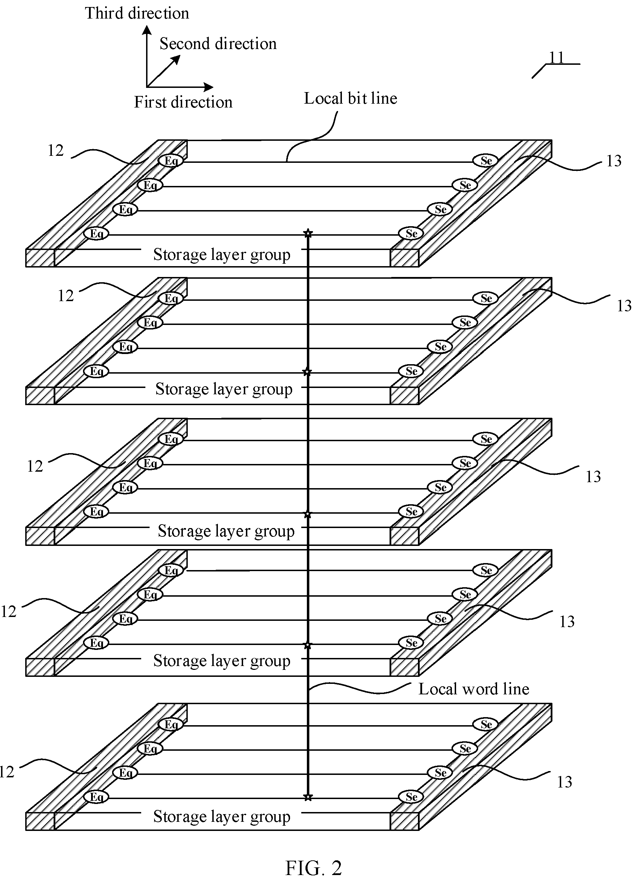

A first chip and a second chip stacked in the third direction are included in a 3D DRAM, memory arrays (Core) are distributed in the first chip, and a peripheral control region (Periphery) and a sense amplification region are distributed in the second chip. For the first chip, a large quantity of memory cells are included in the memory array (Core), and the memory cells are further divided into multiple memory array tiles (Mat), so that control and management are better performed. FIG. 1A is a schematic structural diagram of a memory array tile 11 in a first chip. As shown in FIG. 1A, multiple sub array tiles sequentially arranged in the second direction are included in each memory array tile 11. Multiple storage regions sequentially stacked in the third direction are included in each sub array tile. Two storage layer groups arranged in the first direction are included in each storage region, and a stair contact structure (Staircase) 14 is disposed between a first storage layer group and a second storage layer group. FIG. 1B is an enlarged schematic diagram of a partial structure in FIG. 1A. As shown in FIG. 1B, each storage layer group includes multiple local bit lines (Local BL) extending in a first direction, a local word line (Local WL) runs through multiple storage layer groups in a third direction, and a memory cell is formed at a convergence position of the local word line and the local bit line (shown by a five-pointed star in FIG. 1B). FIG. 2 is a specific schematic structural diagram of each storage layer group in the memory array tile 11. As shown in FIG. 2, a first common bit line (Common BL) 12 and a second common bit line 13 are respectively disposed on both left and right sides of each storage layer group, left ends of all local bit lines in the storage layer group are connected to the first common bit line 12 on the left through a precharge switch Eq, right ends of all local bit lines in the storage layer group are connected to the second common bit line 13 on the right through a bit line selector Se, and each second common bit line is coupled to a sense amplifier (SA) in a sense amplification region through a stair contact structure 14.

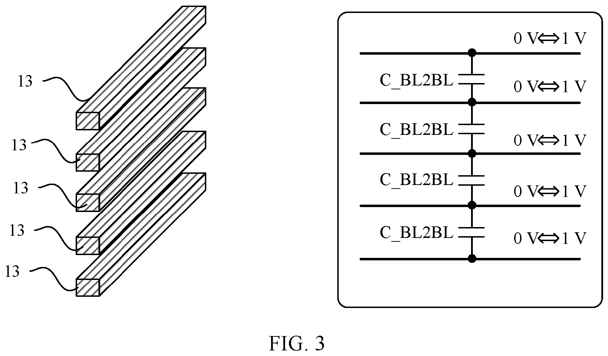

Data reading is taken as an example. A group of target memory cells aligned in the third direction is enabled by opening a target word line, and bit line selectors Se of local bit lines connected to this group of target memory cells are turned on. In this case, each target memory cell is connected to a respective corresponding second common bit line 13, so that a group of second common bit lines 13 aligned in the third direction share charges with a respective target memory cell, sense amplification is performed, and the target memory cell is at a high potential or a low potential (which depends on data stored in the target memory cell). A bit line selector Se of an unselected local bit line is turned off and a precharge switch Eq is turned on, and all first common bit lines 12 are charged to a precharge potential, so that all unselected local bit lines are at the precharge potential. Herein, the precharge potential may be an intermediate potential, and the intermediate potential may be half of a power voltage (Vblh) of a memory array, that is, the intermediate potential=1/2 Vblh. That is, in the foregoing scenario, the first common bit lines 12 are at a precharge potential, and the second common bit lines 13 are at a high potential or a low potential. Because a parasitic capacitance exists between two common bit lines adjacent in the third direction, serious bit line-to-bit line coupling (BL-to-BL Coupling) occurs. For example, in FIG. 3, a coupling capacitance between adjacent second common bit lines is denoted as C_BL2BL. It is assumed that a second common bit line 13 changes from 0 V to a high potential (for example, 1 V) after charge sharing and sense amplification processing, and a voltage of an adjacent second common bit line 13 also increases due to bit line-to-bit line coupling, so that a potential of the adjacent second common bit line 13 may not accurately represent data stored in a corresponding target memory cell. Similar problems exist in data writing.

In short, in a memory array tile, local bit lines of the same storage layer group share one first common bit line and the same second common bit line, a bit line selector is adopted to choose whether to access the second common bit line, and a precharge switch is adopted to choose whether to access the first common bit line. The second common bit line of each layer is interconnected to a sense amplifier (SA) through a corresponding stair contact structure 14. In this case, sense amplification occurs on the same side for second common bit lines of each layer, and there is serious bit line-to-bit line coupling, thereby causing a loss of a sensing margin.

The following describes the embodiments of the present disclosure in detail with reference to the accompanying drawings.

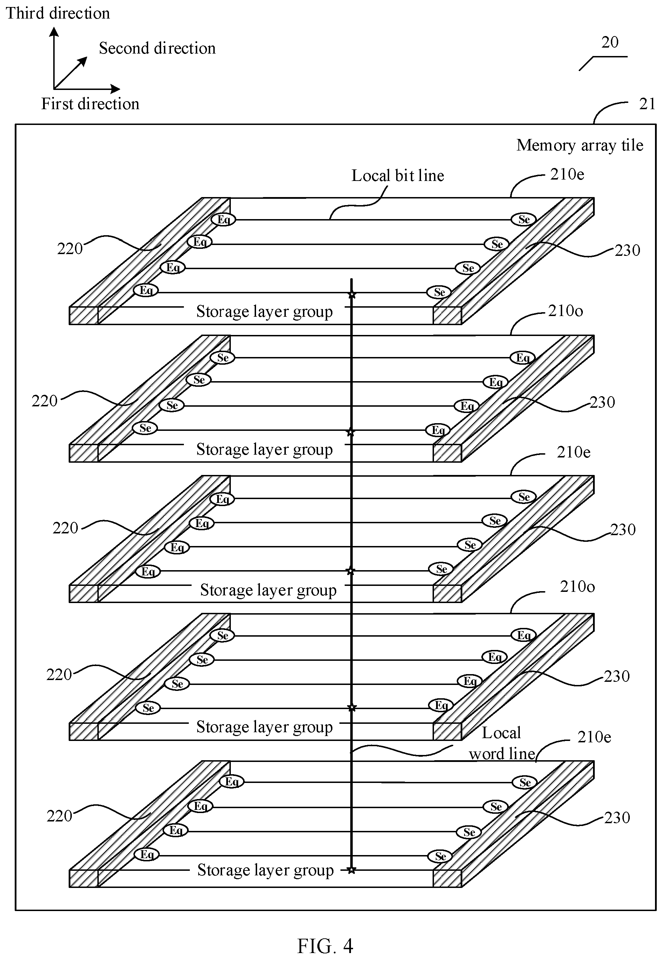

In an embodiment of the present disclosure, a memory is provided. The memory includes a first chip 20. FIG. 4 is a schematic structural diagram of the first chip 20 according to an embodiment of the present disclosure. As shown in FIG. 4, the first chip 20 includes multiple memory array tiles 21 (only one is shown in FIG. 4). The multiple memory array tiles 21 may be arranged in a first direction, or arranged in a second direction, or distributed in an array in a first direction and a second direction.

Each memory array tile 21 includes multiple storage layer groups (for example, 210o, 210e, and ... in FIG. 4) sequentially stacked in a third direction. Each storage layer group has multiple local bit lines extending in the first direction, and the multiple local bit lines are sequentially arranged in the second direction. A first side of each storage layer group (for example, the left side in FIG. 4) has a first common bit line 220, and a second side of each storage layer group (for example, the right side in FIG. 4) has a second common bit line 230.

It should be noted that the first side and the second side are opposite to each other in the first direction. The first direction intersects the second direction, and the third direction is perpendicular to the first direction and the second direction. For example, the first direction is perpendicular to the second direction, or the first direction and the second direction may be at an angle. In FIG. 4, both the first common bit line 220 and the second common bit line 230 extend in the second direction, but this does not constitute a related limitation.

Each storage layer group further includes multiple bit line selectors Se and multiple precharge switches Eq, each local bit line corresponds to one separate bit line selector Se, and each local bit line corresponds to one separate precharge switch Eq.

Herein, the bit line selectors Se and the multiple precharge switches Eq are all switch components. For example, the bit line selector Se adopts a CMOS switch, and the precharge switch Eq adopts a CMOS switch.

For ease of description, the multiple storage layer groups are numbered in the third direction. For example, in FIG. 4, in a bottom-up manner, the 0th storage layer group is numbered 210e, the first storage layer group is numbered 210o, the second storage layer group is numbered 210e, the third storage layer group is numbered 210o, and so on.

In an odd-numbered storage layer group 210o, each local bit line is coupled to a respective first common bit line 220 through a respective bit line selector Se, and each local bit line is coupled to a respective second common bit line 230 through a respective precharge switch Eq. In an even-numbered storage layer group 210e, each local bit line is coupled to a respective first common bit line 220 through a respective precharge switch Eq, and each local bit line is coupled to a respective second common bit line 230 through a respective bit line selector.

It should be noted that, in FIG. 4, each memory array tile includes five storage layer groups, but this is merely an example and does not constitute a limitation. In addition, each storage layer group schematically shows four local bit lines, but actually, a quantity of local bit lines in each storage layer group may be more or less.

It should be understood that, for common bit lines connected to local bit lines through bit line selectors Se, in a read operation, a write operation, or another operation involving data, a function thereof is to perform charge sharing with a selected memory cell and perform sense amplification processing under the action of a sense amplifier. For common bit lines connected to local bit lines through precharge switches Eq, in a read operation, a write operation, or another operation involving data, a function thereof is to provide a precharge potential. For example, the precharge potential may be an intermediate potential 1/2Vblh, and Vblh is a power potential of a memory array, or may be understood as a power potential of a sense amplifier.

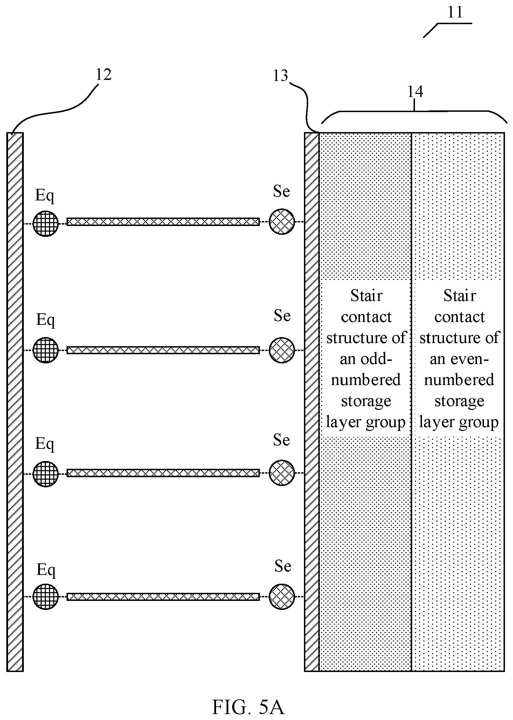

FIG. 5A is a schematic top view of a memory array tile 11 (the memory array tile 11 shown in FIG. 1A to FIG. 3). As shown in FIG. 5A, in the memory array tile 11, for all storage layer groups, the precharge switches Eq are located on the left side, the bit line selectors Se are located on the right side, and precharge switches Eq/bit line selectors Se of different storage layer groups overlap in projection in the third direction, resulting in synchronous sense amplification of multiple second common bit lines 13 aligned in the third direction, thereby causing a serious bit line-to-bit line coupling problem.

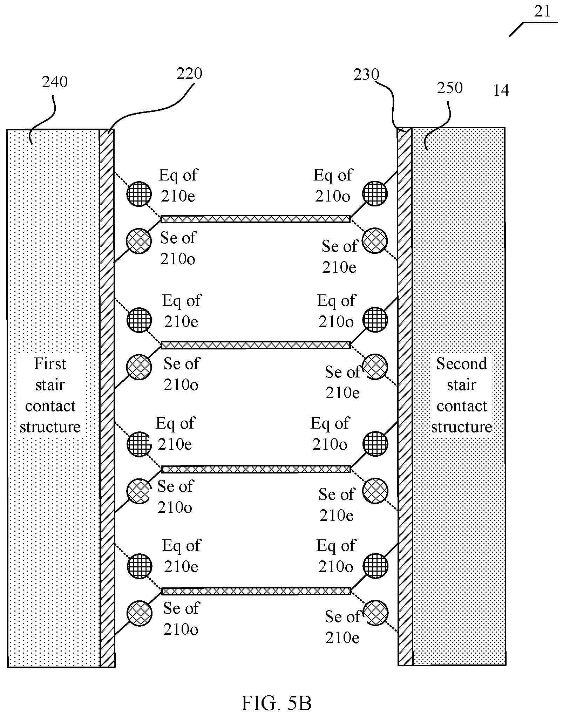

FIG. 5B is a schematic top view of a memory array tile 21 according to an embodiment of the present disclosure. As shown in FIG. 5B, for an odd-numbered storage layer group 210o, a bit line selector Se thereof is located on the left side and a precharge switch Eq thereof is located on the right side. For an even-numbered storage layer group 210e, a precharge switch Eq thereof is on the left side and a precharge switch Eq thereof is on the right side. In particular, in FIG. 5B, the bit line selector Se of the odd-numbered storage layer group 210o and the precharge switch Eq of the even-numbered storage layer group 210e may overlap, and the precharge switch Eq of the odd-numbered storage layer group 210o and the bit line selector Se of the even-numbered storage layer group 210e may overlap. Herein, they are drawn separately for convenience of viewing.

Specifically, for the first chip 20, first common bit lines 220 of two adjacent storage layer groups are adjacent in the third direction, and second common bit lines 230 of two adjacent storage layer groups are adjacent in the third direction, but any first common bit line 220 and any second common bit line 230 are not adjacent in the third direction. In addition, for the odd-numbered storage layer group 210o, the local bit line is connected to the first common bit line 220 through the bit line selector Se, and is connected to the second common bit line 230 through the precharge switch Eq. For the even-numbered storage layer group 210e, the local bit line is connected to the second common bit line 230 through the bit line selector Se, and is connected to the first common bit line 220 through the precharge switch Eq. Therefore, in a process of sense amplification processing, for multiple selected storage layer groups, for two adjacent first common bit lines 220, it is inevitable that one first common bit line 220 is in a sense amplification state (at a high potential or a low potential, which depends on a specific data value), and the other first common bit line 220 is at a precharge potential. For two adjacent second common bit lines 230, it is inevitable that one second common bit line 230 is in a sense amplification state (at a high potential or a low potential, which depends on a specific data value), and the other second common bit line is at a precharge potential, where the low potential < the precharge potential < the high potential. However, sense amplification processing is not simultaneously performed on two adjacent common bit lines, so that the two common bit lines adjacent in the third direction are not simultaneously in the sense amplification state. Therefore, coupling of the two adjacent common bit lines obviously weakens, and a sensing margin is increased.

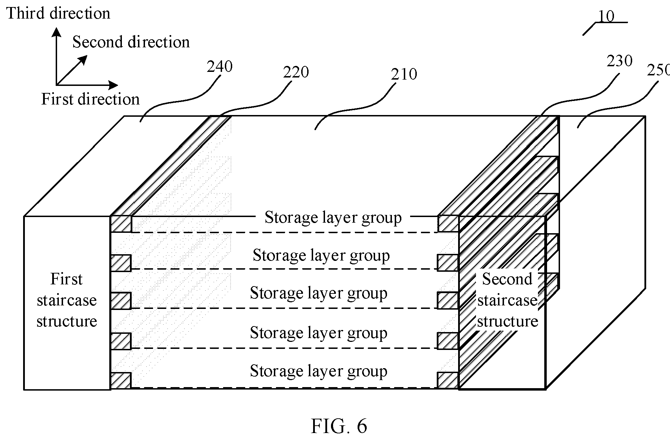

In some embodiments, referring to FIG. 6, a first stair contact structure 240 is further disposed on a first side of the first common bit line 220, a second stair contact structure 250 is further disposed on a second side of the second common bit line 230, and both the first stair contact structure 240 and the second stair contact structure 250 are connected to a sense amplification region; and a first common bit line 220 of the odd-numbered storage layer group 210o is connected to the first stair contact structure 240, and a second common bit line 230 of the even-numbered storage layer group 220e is connected to the second stair contact structure 250.

It should be noted that multiple sense amplifiers (SA) are included in the sense amplification region, which are also referred to as sensitive amplifiers. By performing sense amplification on an electrical signal of a common bit line connected to a selected memory cell, a potential of the common bit line finally reaches a low potential or a high potential, so that data is read from or written into the selected memory cell.

Herein, a storage structure is formed by vertically stacking multiple layers of memory cells (namely, multiple storage layer groups) in a 3D DRAM. In this case, to ensure that the sense amplifier can be successfully connected to the common bit line in each storage layer group, a 3D stair contact structure (Staircase) needs to be formed. Different stairs of the stair contact structure are electrically isolated, and one stair is correspondingly connected to one common bit line (connected to the bit line connector Se). Further, the common bit line is connected to the sense amplifier SA in the sense amplification region, to implement sense amplification processing.

In addition, for the odd-numbered storage layer group 210o, the local bit line is connected to the first common bit line 220 through the bit line selector Se. For the even-numbered storage layer group 210e, the local bit line is connected to the second common bit line 230 through the bit line selector Se. Therefore, two adjacent storage layer groups in the third direction are respectively subjected to sense amplification (Sensing) on the first common bit line 220 and the second common bit line 230. For two adjacent common bit lines in the third direction, it is inevitable that one is in a sense amplification state (at a low potential or a high potential), and the other is at a precharge potential, so that bit line-to-bit line coupling is reduced, and a margin of sensitive amplification is increased. In addition, the stair contact structures are evenly distributed on two sides of the memory array tile 21, and no additional area is added.

In some embodiments, both the first stair contact structure 240 and the second stair contact structure 250 include multiple stairs; each first common bit line 220 of the odd-numbered storage layer group 210o is coupled to one sense amplifier in the sense amplification region through one stair of the first stair contact structure 240; and each second common bit line 230 of the even-numbered storage layer group 210e is coupled to one sense amplifier in the sense amplification region through one stair of the second stair contact structure 250.

In a case in which a quantity of stacked layers of storage layer groups is relatively large, the area of a staircase structure region gradually increases, thereby increasing chip manufacturing costs. To reduce the stair area, a grouped stair contact structure is adopted in this embodiment of the present disclosure.

In some embodiments, for the first stair contact structure 240, several successive stairs form one stair group, and multiple stair groups are arranged at an interval in the second direction; and for the second stair contact structure 250, several successive stairs form one stair group, and multiple stair groups are arranged at an interval in the second direction.

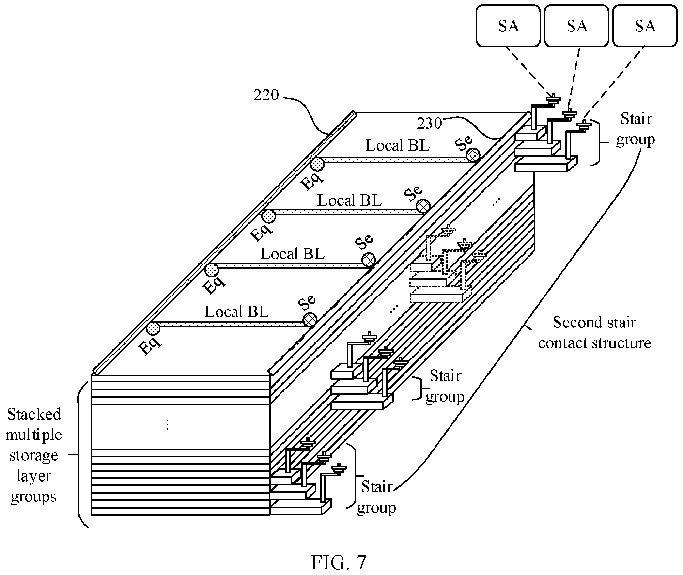

FIG. 7 is a schematic diagram of a connection of a stair group according to an embodiment of the present disclosure. FIG. 7 shows an example in which each stair group includes three stairs. For convenience of description, storage layer groups are labeled from bottom to top, second common bit lines 230 of the 0th, 2nd, and 4th storage layer groups are connected to the first stair group of the second stair contact structure 250 in a one-to-one correspondence, second common bit lines 230 of the 6th, 8th, and 10th storage layer groups are connected to the second stair group of the second stair contact structure 250 in a one-to-one correspondence, and so on. In addition, first common bit lines 220 of all odd-numbered storage layer groups (the 1st, 3rd, 5th, and ... storage layer groups) are connected to the first stair contact structure 240 (not shown in the figure due to being blocked).

In this way, different stair groups are sequentially arranged in the second direction, and the size of each stair in the first direction does not need to be designed to be excessively long.

In addition, in FIG. 7, different stairs in the same stair group are spaced apart, but this is only for more intuitively illustrating a connection relationship between the stair group and a corresponding storage layer group. In an actual application scenario, different stairs in the same stair group may be closely connected, provided that the foregoing connection relationship with the storage layer group is followed.

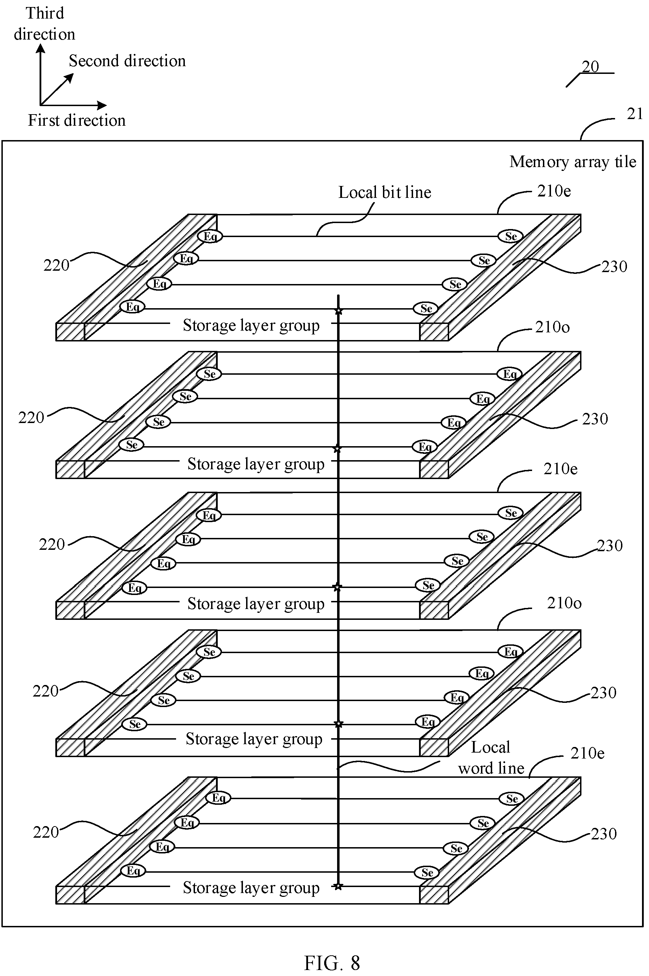

In some embodiments, referring to FIG. 8, in an odd-numbered storage layer group 210o, each precharge switch Eq is located on a third side of a corresponding local bit line (for example, the side facing outwards along the paper plane in FIG. 7), and each bit line selector Se is located on a fourth side of a corresponding local bit line (for example, a side facing inward along the paper plane in FIG. 7). The third side and the fourth side are opposite to each other in the second direction. In an even-numbered storage layer group 210e, each precharge switch Eq is located on a fourth side of a corresponding local bit line, and each bit line selector Se is located on a third side of a corresponding local bit line.

That is, referring to FIG. 5A, in the memory array tile 11, for all storage layer groups, the precharge switches Eq are located on the left side, the bit line selectors Se are located on the right side, and precharge switches Eq/bit line selectors Se of different storage layer groups overlap in projection in the third direction, resulting in synchronous sense amplification of multiple second common bit lines 13 aligned in the third direction, thereby causing a serious bit line-to-bit line coupling problem.

Referring to FIG. 5B, for an odd-numbered storage layer group 210o, a bit line selector Se thereof is located at the lower left side and a precharge switch Eq thereof is located at the upper right side. For an even-numbered storage layer group 210e, a precharge switch Eq thereof is located at the upper left side and a bit line selector Se thereof is located at the lower right side.

In this way, for the same storage layer group, a bit line selector Se and a precharge switch Eq thereof are respectively located on two sides, in the second direction, of a local bit line to which they belong, and the layout is more reasonable. In addition, for two storage layer groups adjacent in the third direction, a bit line selector Se of one storage layer group and a precharge switch Eq of the other storage layer group do not overlap in projection in the third direction, so as to avoid coupling between switches.

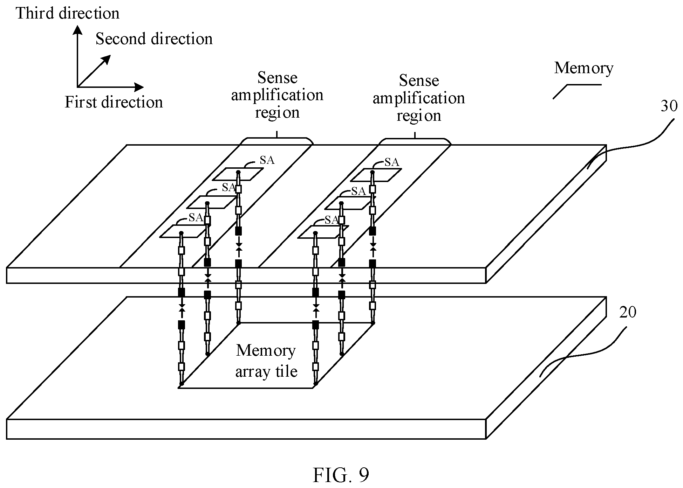

In some embodiments, referring to FIG. 9, the foregoing memory is a three-dimensional memory, and further includes a second chip 30. The first chip 20 and the second chip 30 are stacked in the third direction, and the first chip 20 is bonded to the second chip 30. The foregoing sense amplification region is located in the second chip 30.

It should be noted that the bonding connection means that two chips are electrically connected through a hybrid bonding (also referred to as a bonding pillar) structure. Hybrid bonding refers to a process of creating permanent bonding between heterogeneous or homogeneous chips. "Hybrid" refers to forming dielectric-dielectric and metal-metal bonding between two surfaces, and has the following advantages: (1) Shorter interconnection distance: No lead is required for interconnection, and no TSV is required for crossing the entire CMOS layer. Interconnection can be implemented simply by a copper contact connected to a rear channel. (2) Higher interconnection density: An area of a copper contact is extremely small. In comparison with a solder ball and a TSV with a diameter of one hundred microns, a pitch size of the copper contact in a hybrid bonding process is even less than 10 microns, which can undoubtedly achieve a higher interconnection density. (3) Lower costs: It undoubtedly takes more time to interconnect each chip individually. A large area of high-density interconnection can be implemented through wafer bonding, which contributes significantly to the improvement of production capacity. Naturally, production costs can be reduced.

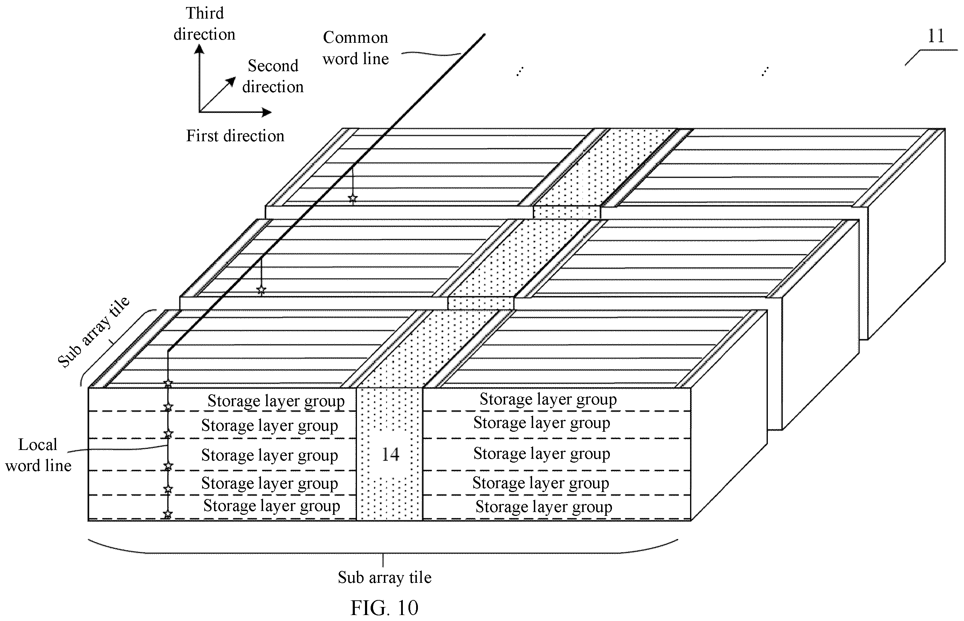

In some embodiments, referring to FIG. 10, each memory array tile 21 further includes multiple local word lines (only one is shown in FIG. 10), and each local word line runs through multiple storage layer groups in the third direction. One memory cell (five-pointed star in FIG. 10) is formed at an intersection of each local word line and a corresponding local bit line.

In this way, each local word line enables multiple memory cells aligned in the third direction, and the multiple memory cells synchronously perform reading/writing. In addition, for two memory cells adjacent in the third direction, it is inevitable that one memory cell performs reading/writing through a first common bit line 220 on one side, and the other memory cell performs reading/writing through a first common bit line 220 on the other side. Therefore, bit line-to-bit line coupling has a relatively small impact, and memory performance can be improved.

In some embodiments, referring to FIG. 10, the memory further includes multiple common word lines (only one in FIG. 10) extending in the second direction, and multiple local word lines aligned in the second direction are coupled to the same common word line.

Specifically, the first local word line in each sub array tile is coupled to one common word line, the second local word line in each sub array tile is coupled to another common word line, the third local word line in each sub array tile is coupled to still another common word line, and so on.

In some embodiments, a memory cell formed at an intersection of a local word line and a local bit line includes at least a 1T1C structure or another storage structure that is known and feasible. The 1T1C structure includes one N-type transistor and one capacitor.

The memory 20 is configured to: in a process of a read operation or a write operation, for a selected memory cell, control the bit line selector Se of the local bit line connected to the selected memory cell to be in an on state, and control the precharge switch Eq of the local bit line connected to the selected memory cell to be in an off state; and for an unselected memory cell, control the bit line selector Se of the local bit line connected to the unselected memory cell to be in an off state, and control the precharge switch Eq of the local bit line connected to the unselected memory cell to be in an on state.

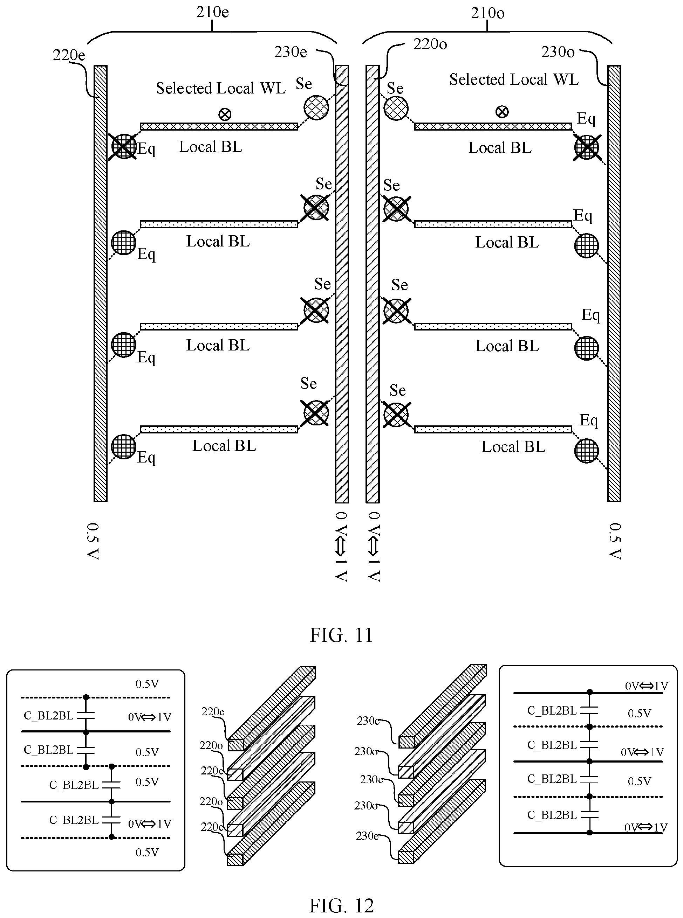

FIG. 11 is a schematic diagram of a working state of a memory array tile according to an embodiment of the present disclosure. In particular, FIG. 11 is a top view of an odd-numbered storage layer group 210o and an even-numbered storage layer group 210e. When a selected local word line (Local WL) is enabled, multiple memory cells aligned in the third direction are enabled. In this case, a bit line selector Se of a local bit line (Local BL) corresponding to the selected local word line is in an on state and a precharge switch Eq thereof is in an off state. In addition, a bit line selector Se of a local bit line (Local BL) corresponding to an unselected local word line is in an off state and a precharge switch Eq thereof is in an on state. To be specific,
(1) Referring to FIG. 11, for the odd-numbered storage layer group 210o, the fourth local bit line (Local BL) (numbered from bottom to top) is connected to the first common bit line 220o on the left through the bit line selector Se, so that the voltage of the first common bit line 220o gradually increases from 0 V (it is assumed that data 1 is read), and after sense amplification, reaches 1 V. However, the second common bit line 230o is precharged to a precharge potential (for example, 0.5 V), and the first to the third local bit lines (Local BL) are all connected to the second common bit line 230o through corresponding precharge switches Eq, so that the first to the third local bit lines (Local BL) are maintained to the precharge potential 0.5 V.
(2) Referring to FIG. 11, for the even-numbered storage layer group 210e, the fourth local bit line is connected to the second common bit line 230e on the right through the bit line selector Se, so that the voltage of the second common bit line 230e gradually increases from 0 V (it is assumed that data 1 is read), and after sense amplification, reaches 1 V. However, the first common bit line 220e is precharged to a precharge potential 0.5 V, and the first to the third local bit lines (Local BL) are all connected to the first common bit line 220e through corresponding precharge switches Eq, so that the first to the third local bit lines (Local BL) are maintained to the precharge potential 0.5 V.

It should be understood that, in the third direction, the first common bit line 220o (whose voltage changes from 0 V to 1 V by means of charge sharing and sense amplification) is adjacent to the first common bit line 220e (whose voltage is the precharge potential 0.5 V), and the second common bit line 230o (whose voltage is the precharge potential 0.5 V) is adjacent to the second common bit line 230e (whose voltage changes from 0 V to 1 V by means of charge sharing and sense amplification), that is, at most one common bit line in two adjacent common bit lines undergoes sense amplification processing, thereby reducing a bit line-to-bit line coupling problem.

Referring to FIG. 12, in an example with five stacked storage layer groups, first common bit lines 220o of the 1st and 3rd storage layer groups change from 0 V to 1 V, that is, sense amplification processing is performed, and first common bit lines 220e of the 0th, 2nd, and 4th storage layer groups are all precharge potentials 0.5 V, and sense amplification processing is not performed. In addition, second common bit lines 230e of the 0th, 2nd, and 4th storage layer groups change from 0 V to 1 V, that is, sense amplification processing is performed, and second common bit lines 230o of the 1st and 3rd storage layer groups are all precharge potentials 0.5 V, and sense amplification processing is not performed. It can be learned that, adjacent common bit lines on the same side always have a sense-amplified data potential (low potential/high potential) and a precharge potential that alternately occur, thereby reducing a bit line-to-bit line coupling problem, and increasing a sensing margin.

Certainly, the foregoing only adopts an example of the high potential = 1 V and the precharge potential = 0.5 V for description. Certainly, in another embodiment, values of the low potential, the precharge potential, and the high potential may be arbitrary, provided that the low potential < the precharge potential < the high potential is met.

In conclusion, the embodiment of the present disclosure provides the three-dimensional memory. The first chip 20 and the second chip 30 are included in the three-dimensional memory. The first chip 20 and the second chip 30 are stacked in the third direction, and are connected in a hybrid bonding manner. The first chip 20 is mainly utilized to manufacture the memory array (Core), which is specifically divided into multiple memory array tiles (Mat) for better control and management. The second chip 30 is mainly utilized to manufacture the peripheral control region (Periphery) and the sense amplification region. In the first chip 20, each memory array tile includes multiple storage layer groups stacked in the third direction, and common bit lines (Common BL) of an odd-numbered layer (that is, an odd-numbered storage layer group) and an even-numbered layer (that is, an even-numbered storage layer group) are respectively controlled through independent bit line selectors (BL selector) and precharge switches (Eq Device). Local bit lines (Local BL) between storage layer groups adjacent in the third direction will separately undergo sense amplification (Sensing) on both sides of the storage layer group along the first direction. Common bit lines successively arranged in the third direction will be alternately arranged with a sense amplification state (Sensing) and a precharge potential, thereby reducing BL-to-BL coupling. In addition, the memory array tile further includes stair contact structures distributed on both sides, so that a first common bit line of an odd-numbered layer is connected to a stair contact structure (BL staircase) of a first side in the first direction, and a second common bit line of an even-numbered layer is connected to a stair contact structure of a second side in the second direction. The stair contact structures are separately arranged on the two sides, so that the area is not increased.

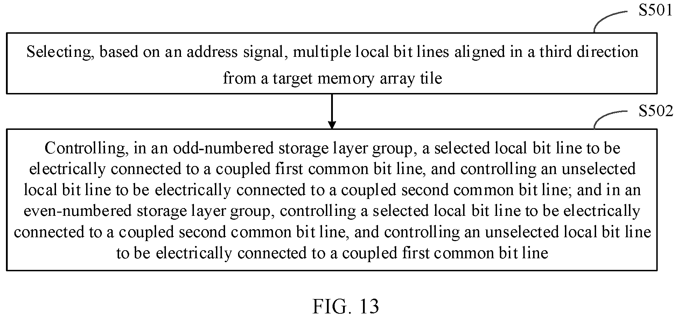

In another embodiment of the present disclosure, FIG. 13 is a schematic flowchart of a test method according to an embodiment of the present disclosure. As shown in FIG. 13, the test method is applied to the memory shown in FIG. 4. The memory includes a first chip 20 and a second chip 30 stacked in a first direction. The first chip 20 includes multiple memory array tiles 21, and each memory array tile includes multiple storage layer groups (for example, 210o, 210e, and ... in FIG. 4) sequentially stacked in a third direction. Each storage layer group has multiple local bit lines extending in the first direction, and the multiple local bit lines are sequentially arranged in a second direction. A first side of each storage layer group (for example, the left side in FIG. 4) has a first common bit line 220, and a second side of each storage layer group (for example, the right side in FIG. 4) has a second common bit line 230. Each storage layer group further includes multiple bit line selectors Se and multiple precharge switches Eq, each local bit line corresponds to one separate bit line selector Se, and each local bit line corresponds to one separate precharge switch Eq. For convenience of description, the multiple storage layer groups are numbered in the third direction. In an odd-numbered storage layer group 210o, each local bit line is coupled to a respective first common bit line 220 through a respective bit line selector Se, and each local bit line is coupled to a respective second common bit line 230 through a respective precharge switch Eq. In an even-numbered storage layer group 210e, each local bit line is coupled to a respective first common bit line 220 through a respective precharge switch Eq, and each local bit line is coupled to a respective second common bit line 230 through a respective bit line selector.

The method includes the steps as follows:
In the step of S501, based on an address signal, multiple local bit lines aligned in a third direction are selected from a target memory array tile.

In the step of S502, in an odd-numbered storage layer group, a selected local bit line is controlled to be electrically connected to a coupled first common bit line, and an unselected local bit line is controlled to be electrically connected to a coupled second common bit line; and in an even-numbered storage layer group, a selected local bit line is controlled to be electrically connected to a coupled second common bit line, and an unselected local bit line is controlled to be electrically connected to a coupled first common bit line.

In some embodiments, the method further includes the steps as follows.

A bit line selector of the selected local bit line is controlled to be in an on state, and a precharge switch of the selected local bit line is controlled to be in an off state, so that the selected local bit line in the odd-numbered storage layer group is electrically connected to the first common bit line, and the selected local bit line in the even-numbered storage layer group is electrically connected to the second common bit line; and
a bit line selector of the unselected local bit line is controlled to be in an off state, and a precharge switch of the unselected local bit line is controlled to be in an on state, so that the unselected local bit line in the odd-numbered storage layer group is electrically connected to the second common bit line, and the unselected local bit line in the even-numbered storage layer group is electrically connected to the first common bit line.

In some embodiments, the method further includes the steps as follows.

A potential of the second common bit line is controlled to be a precharge potential for the odd-numbered storage layer group; and a potential of the first common bit line is enabled to be a low potential or a high potential (which depends on to-be-written data in a write operation or to-be-read data in a read operation) through charge sharing and sense amplification processing; and
a potential of the first common bit line is controlled to be a precharge potential for the even-numbered storage layer group; and a potential of the second common bit line is enabled to be a low potential or a high potential (which depends on to-be-written data in a write operation or to-be-read data in a read operation) through charge sharing and sense amplification processing;
where the low potential < the precharge potential < the high potential.

In this way, for the first chip 20, assuming that a selected local bit line in a storage layer group undergoes sense amplification through a first common bit line on one side in the first direction, a selected local bit line in a storage layer group adjacent thereto necessarily undergoes sense amplification through a second common bit line on the other side in the first direction, that is, two common bit lines adjacent in the third direction do not simultaneously undergo sense amplification processing, so that coupling of the adjacent common bit lines obviously weakens, and a sensing margin is increased.

In still another embodiment of the present disclosure, an electronic device is further provided, where the electronic device includes the memory shown in FIG. 4. The memory includes a first chip 20 and a second chip 30 stacked in a first direction. The first chip 20 includes multiple memory array tiles 21, and each memory array tile includes multiple storage layer groups (for example, 210o, 210e, and ... in FIG. 4) sequentially stacked in a third direction. Each storage layer group has multiple local bit lines extending in the first direction, and the multiple local bit lines are sequentially arranged in a second direction. A first side of each storage layer group (for example, the left side in FIG. 4) has a first common bit line 220, and a second side of each storage layer group (for example, the right side in FIG. 4) has a second common bit line 230. Each storage layer group further includes multiple bit line selectors Se and multiple precharge switches Eq, each local bit line corresponds to one separate bit line selector Se, and each local bit line corresponds to one separate precharge switch Eq. For convenience of description, the multiple storage layer groups are numbered in the third direction. In an odd-numbered storage layer group 210o, each local bit line is coupled to a respective first common bit line 220 through a respective bit line selector Se, and each local bit line is coupled to a respective second common bit line 230 through a respective precharge switch Eq. In an even-numbered storage layer group 210o, each local bit line is coupled to a respective first common bit line 220 through a respective precharge switch Eq, and each local bit line is coupled to a respective second common bit line 230 through a respective bit line selector.

In this way, for the first chip 20, assuming that a selected local bit line in a storage layer group undergoes sense amplification through a first common bit line on one side in the first direction, a selected local bit line in a storage layer group adjacent thereto necessarily undergoes sense amplification through a second common bit line on the other side in the first direction, that is, two common bit lines adjacent in the third direction do not simultaneously undergo sense amplification processing, so that coupling of the adjacent common bit lines obviously weakens, and a sensing margin is increased.

It should be noted that in this specification, the terms "include", "comprise", or any other variant thereof are intended to cover non-exclusive inclusion, so that a process, method, article, or apparatus including a series of elements includes not only those elements but also other elements that are not expressly listed, or further includes elements inherent to such a process, method, article, or apparatus. An element preceded by "includes a... " does not, without more constraints, preclude the presence of additional identical elements in the procedure, method, article, or apparatus including the element.

The sequence numbers of the foregoing embodiments of the present disclosure are merely for the purpose of description, and are not intended to indicate priorities of the embodiments. The methods disclosed in the several method embodiments provided in the present disclosure may be randomly combined when there is no conflict, to obtain new method embodiments. The features disclosed in the several product embodiments provided in the present disclosure may be randomly combined when there is no conflict, to obtain new product embodiments. The features disclosed in the several method or device embodiments provided in the present disclosure may be randomly combined when there is no conflict, to obtain new method embodiments or new device embodiments.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

## Claims

1. A memory, comprising a first chip (20), the first chip comprising a plurality of memory array tiles (21), and each of the memory array tiles comprising a plurality of storage layer groups stacked sequentially in a third direction; each of the storage layer groups having a plurality of local bit lines extending in a first direction, and the plurality of local bit lines being sequentially arranged in a second direction; and a first side of each of the storage layer groups having a first common bit line (220), a second side of each of the storage layer groups having a second common bit line (230), the first side and the second side being opposite to each other in the first direction, the first direction intersecting the second direction, and the third direction being perpendicular to the first direction and perpendicular to the second direction; and
each of the storage layer groups further comprising a plurality of bit line selectors (Se) and a plurality of precharge switches (Eq); and the plurality of storage layer groups being numbered in the third direction:
in an odd-numbered one of the storage layer groups (210o), each of the local bit lines being coupled to a respective first common bit line through a respective bit line selector, and each of the local bit lines being coupled to a respective second common bit line through a respective precharge switch; and
in an even-numbered one of the storage layer groups (210e), each of the local bit lines being coupled to a respective first common bit line through a respective precharge switch, and each of the local bit lines being coupled to a respective second common bit line through a respective bit line selector.

2. The memory according to claim 1, wherein a first stair contact structure (240) is further disposed on a first side of the first common bit line, a second stair contact structure (250) is further disposed on a second side of the second common bit line, and both the first stair contact structure and the second stair contact structure are connected to a sense amplification region; and
a first common bit line of the odd-numbered storage layer group is connected to the first stair contact structure, and a second common bit line of the even-numbered storage layer group is connected to the second stair contact structure.

3. The memory according to claim 2, wherein
both the first stair contact structure and the second stair contact structure comprise a plurality of stairs;
each first common bit line of the odd-numbered storage layer group is coupled to one sense amplifier in the sense amplification region through one stair of the first stair contact structure; and
each second common bit line of the even-numbered storage layer group is coupled to one sense amplifier in the sense amplification region through one stair of the second stair contact structure.

4. The memory according to claim 2, wherein
for the first stair contact structure, several successive stairs form one stair group, and a plurality of stair groups are arranged at an interval in the second direction; and
for the second stair contact structure, several successive stairs form one stair group, and a plurality of stair groups are arranged at an interval in the second direction.

5. The memory according to claim 2, wherein the memory further comprises a second chip (30), the first chip and the second chip are stacked in the third direction, and the first chip is bonded to the second chip; and
the sense amplification region is located in the second chip.

6. The memory according to claim 5, wherein
each of the memory array tiles further comprises a plurality of local word lines, and each of the local word lines runs through a plurality of storage layer groups in the third direction.

7. The memory according to claim 6, wherein the memory further comprises a plurality of common word lines extending in the second direction, and a plurality of ones of the local word lines aligned in the second direction are coupled to a same common word line.

8. The memory according to claim 7, wherein the storage layer group further comprises a plurality of memory cells, and each of the memory cells is separately connected to one of the local bit lines and one of the local word lines; and
the memory is configured to: in a process of a read operation or a write operation, for a selected memory cell, control the bit line selector of the local bit line connected to the selected memory cell to be in an on state, and control the precharge switch of the local bit line connected to the selected memory cell to be in an off state; and for an unselected memory cell, control the bit line selector of the local bit line connected to the unselected memory cell to be in an off state, and control the precharge switch of the local bit line connected to the unselected memory cell to be in an on state.

9. The memory according to any one of claims 1 to 8, wherein
in the odd-numbered storage layer group, each precharge switch is located on a third side of the corresponding local bit line, and each bit line selector is located on a fourth side of the corresponding local bit line; and the third side and the fourth side are opposite to each other in the second direction; and
in the even-numbered storage layer group, each precharge switch is located on a fourth side of the corresponding local bit line, and each bit line selector is located on a third side of the corresponding local bit line.

10. The memory according to claim 9, wherein
both the bit line selector and the precharge switch are CMOS switches.

11. A bit line control method, applied to the memory according to any one of claims 1 to 10, comprising:
selecting, based on an address signal, a plurality of local bit lines aligned in a third direction from a target memory array tile (S501); and
controlling, in an odd-numbered storage layer group, a selected local bit line to be electrically connected to a first common bit line of a storage layer group to which the local bit line belongs, and controlling an unselected local bit line to be electrically connected to a second common bit line of a storage layer group to which the local bit line belongs; and in an even-numbered storage layer group, controlling a selected local bit line to be electrically connected to a second common bit line of a storage layer group to which the local bit line belongs, and controlling an unselected local bit line to be electrically connected to a first common bit line of a storage layer group to which the local bit line belongs (S502).

12. The bit line control method according to claim 11, further comprising:
controlling a bit line selector of the selected local bit line to be in an on state, and a precharge switch of the selected local bit line to be in an off state, so that the selected local bit line in the odd-numbered storage layer group is electrically connected to the first common bit line, and the selected local bit line in the even-numbered storage layer group is electrically connected to the second common bit line; and
controlling a bit line selector of the unselected local bit line to be in an off state, and a precharge switch of the unselected local bit line to be in an on state, so that the unselected local bit line in the odd-numbered storage layer group is electrically connected to the second common bit line, and the unselected local bit line in the even-numbered storage layer group is electrically connected to the first common bit line.

13. The bit line control method according to claim 11, further comprising:
controlling a potential of the second common bit line to be a precharge potential for the odd-numbered storage layer group; and enabling a potential of the first common bit line to be a low potential or a high potential through charge sharing and sense amplification processing; and
controlling a potential of the first common bit line to be a precharge potential for the even-numbered storage layer group; and enabling a potential of the second common bit line to be a low potential or a high potential through charge sharing and sense amplification processing;
wherein the low potential < the precharge potential < the high potential.

14. An electronic device, comprising the memory according to any one of claims 1 to 10.
